# EUROPEAN PATENT APPLICATION

(11) **EP 1 126 322 A2**
(43) Date of publication of application: **22.08.2001**
(21) Application number: 01301347.9
(22) Date of filing: 16.02.2001
(51) Int. Cl.: G03F 7/039, C08F 20/22, C08F 20/24, C08F 32/00, C08F 32/08, C08F 22/40, C08F 22/18, G03F 7/004

(54) **Fluorine-containing polymers, resist compositions and patterning process**

(30) Priority: 16.02.2000 JP 2000038309
(71) Applicant: SHIN-ETSU CHEMICAL CO., LTD., Chiyoda-ku Tokyo (JP)
(72) Inventor: Harada, Yuji, c/o Speciality Chemicals Res. Center, Kubiki-mura, Nakakubiki-gun, Niigata-ken (JP); Watanabe, Jun, c/o Speciality Chem. Res. Center, Kubiki-mura, Nakakubiki-gun, Niigata-ken (JP); Hatakeyama, Jun, c/o Speciality Chem. Res. Center, Kubiki-mura, Nakakubiki-gun, Niigata-ken (JP)
(74) Representative: Stoner, Gerard Patrick

(57) **Abstract**

Polymers having fluorinated ester groups are novel. Using the polymers, resist compositions featuring low absorption of F₂ excimer laser light are obtained.

## Description

This invention relates to polymers useful as the base resin in resist compositions, especially chemical amplification resist compositions, suited for microfabrication. It also relates to resist compositions comprising the polymers, and a patterning process using the same.

### BACKGROUND

In the drive for higher integration and operating speeds in LSI devices, the pattern rule is made drastically finer. The rapid advance toward finer pattern rules is grounded on the development of a projection lens with an increased NA, a resist material with improved performance, and exposure light of a shorter wavelength. To the demand for a resist material with a higher resolution and sensitivity, acid-catalyzed chemical amplification positive working resist materials are effective as disclosed in USP 4,491,628 and USP 5,310,619 (JP-B 2-27660 and JP-A 63-27829). They now become predominant resist materials especially adapted for deep UV lithography. In particular, the change-over from i-line (365 nm) to shorter wavelength KrF laser (248 nm) brought about a significant innovation. Resist materials adapted for KrF excimer lasers enjoyed early use on the 0.30 micron process, went through the 0.25 micron rule, and currently entered the mass production phase on the 0.18 micron rule. Engineers have started investigation on the 0.15 micron rule, with the trend toward a finer pattern rule being accelerated.

With respect to ArF laser (193 nm), it is expected to enable miniaturization of the design rule to 0.13 µm or less. Since conventionally used novolac resins and polyvinylphenol resins have very strong absorption in proximity to 193 nm, they cannot be used as the base resin for resists. To ensure transparency and dry etching resistance, some engineers investigated acrylic and alicyclic (typically cycloolefin) resins as disclosed in JP-A 9-73173, JP-A 10-10739, JP-A 9-230595 and WO 97/33198.

With respect to F₂ excimer laser (157 nm) which is expected to enable further miniaturization to 0.10 µm or less, more difficulty arises in insuring transparency. It was found that acrylic resins useful as the base polymer for ArF are not transmissive to light at all and those cycloolefin resins having carbonyl bonds have strong absorption. Also, polyvinyl phenol useful as the base polymer for KrF has a window for absorption in proximity to 160 nm, so the transmittance is somewhat improved, but far below the practical level.

An object of the invention is to provide novel polymers useful as base polymers in resist compositions, preferably having a high transmittance to vacuum ultraviolet radiation in the wavelength range up to 300nm, and preferably any one or more of F₂ excimer laser beam (157 nm), Kr₂ excimer laser beam (146 nm), KrAr excimer laser beam (134 nm) and Ar₂ excimer laser beam (121 nm). Other aspects are novel resist compositions comprising such polymers, and patterning processes using them.

We have found that by using as base resin a polymer having fluorinated ester groups, resist compositions featuring transparency and alkali solubility can be obtained.

In a first aspect, the invention provides a polymer having groups of the following general formula (1). 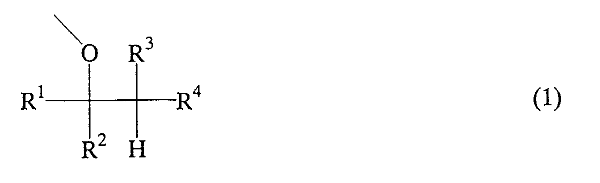 Herein R¹, R², R³ and R⁴ are independently hydrogen, fluorine or unsubstituted or fluorinated, straight, branched or cyclic alkyl groups of 1 to 20 carbon atoms, and at least one of R¹, R², R³ and R⁴ is or contains fluorine.

In one preferred embodiment, the polymer includes recurring units represented by the following general formula (2-1), (2-2), (2-3), (2-4) or (2-5). 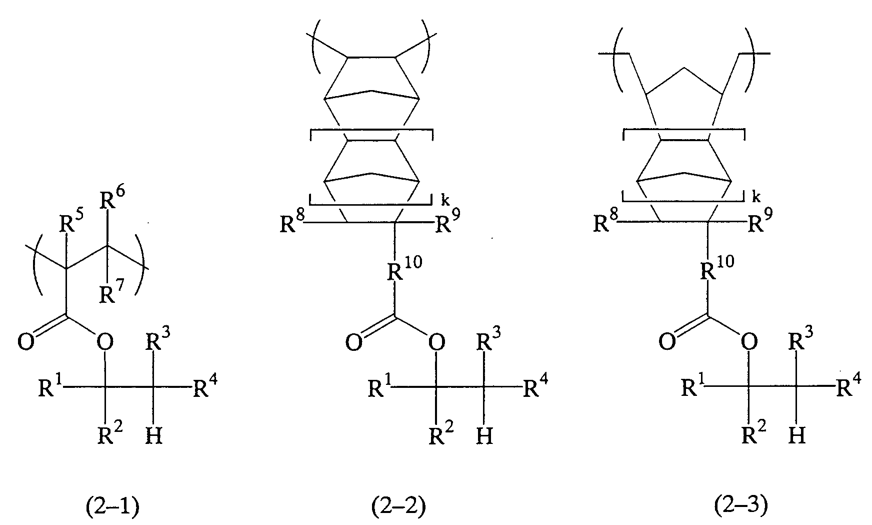 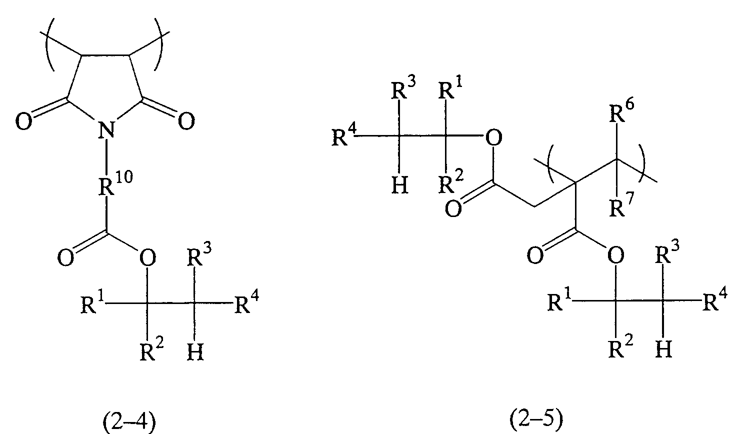 Herein R¹ to R⁴ are as defined above; R⁵, R⁶ and R⁷ are independently hydrogen, fluorine or unsubstituted or fluorinated, straight, branched or cyclic alkyl groups of 1 to 20 carbon atoms; R⁸ and R⁹ are independently hydrogen, methyl or CH₂CO₂R¹¹; R¹⁰ is an unsubstituted or fluorinated, straight, branched or cyclic alkylene group of 1 to 20 carbon atoms; R¹¹ is a substituted or unsubstituted, straight, branched or cyclic alkyl group of 1 to 20 carbon atoms; and k is equal to 0 or 1.

In a second aspect, the invention provides a resist composition comprising polymer as defined above. One embodiment of the invention is a chemical amplification, positive resist composition comprising (A) the polymer defined above, (B) an organic solvent, and (C) a photoacid generator. In preferred embodiments, the resist composition further includes a basic compound and/or a dissolution inhibitor.

In a further aspect, the invention provides a process for forming a pattern, comprising the steps of (1) applying the chemical amplification resist composition defined above onto a substrate to form a coating; (2) heat treating the coating and exposing the coating to high energy radiation with a wavelength of up to 300 nm or electron beam through a photo-mask; (3) optionally heat treating the exposed coating, and developing the coating with a developer.

For the purpose of increasing the transmittance in proximity to 157 nm, reducing the number of carbonyl and carbon-to-carbon double bonds is believed effective while it has been found that the introduction of fluorine atoms into the base polymer greatly contributes to an improvement in transmittance. In fact, a polymer having fluorine introduced into the aromatic rings of polyvinyl phenol has a transmittance of nearly practically acceptable level. This base polymer, however, was found difficult to use as the resist in practice because it undergoes substantial negative conversion upon exposure to high energy radiation such as F₂ laser light. In contrast, a polymer obtained by introducing fluorine into an acrylic resin or a polymer comprising as the backbone an aliphatic cyclic compound originating from a norbornene derivative has been found to have a minimized absorption at the desired wavelength and eliminate the negative working problem. In particular, an ester polymer having fluorinated alkyl groups introduced therein not only has a further enhanced transmittance in proximity to 157 nm, but is so acid labile that the effect of enhancing the contrast of alkali dissolution is exerted.

### DETAILED DESCRIPTION; PREFERENCES AND OPTIONS Polymer

The polymer or high molecular weight compound is defined as having groups of the following general formula (1), particularly in which the -O is of an ester group, and especially recurring units of any of the following general formulas (2-1) to (2-5). Units of formula (1) e.g. (2) preferably constitute at least 10mol%, more preferably at least 20 or 30mol%, of monomer residues in the polymer.

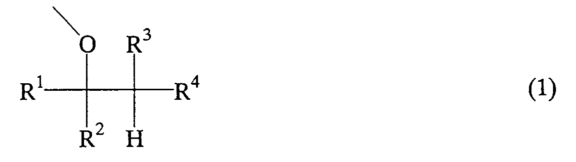

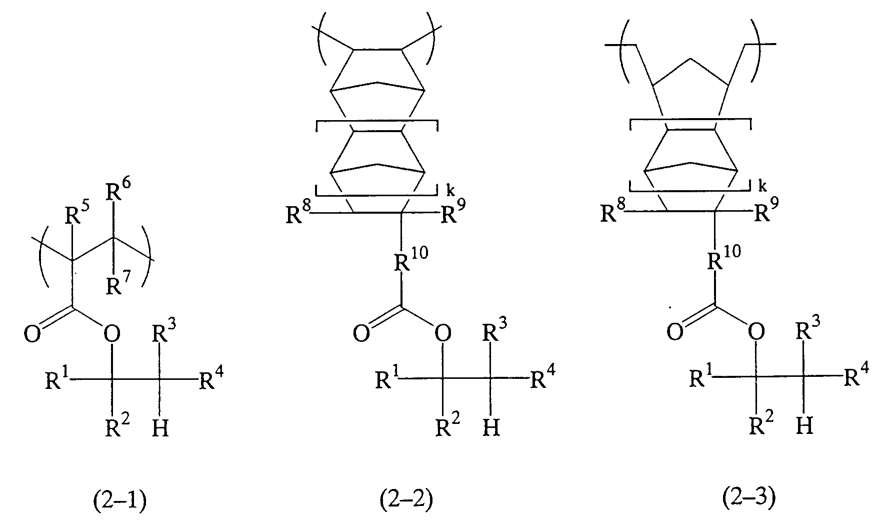

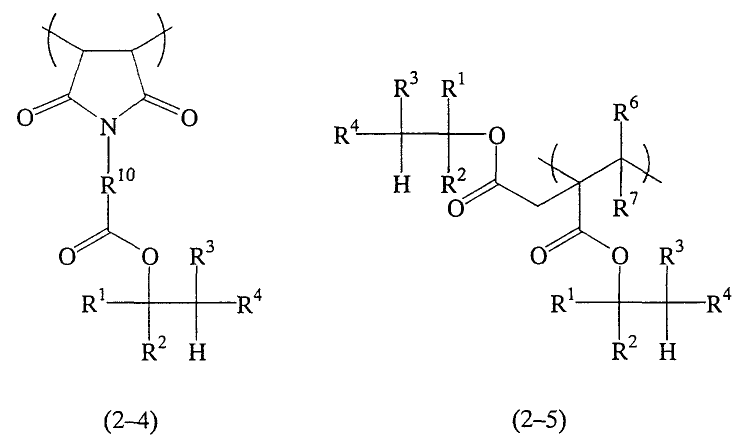

Herein R¹, R², R³ and R⁴ are independently hydrogen, fluorine or unsubstituted or fluorinated, straight, branched or cyclic alkyl groups of 1 to 20 carbon atoms, and at least one of R¹, R², R³ and R⁴ contains fluorine. R⁵, R⁶ and R⁷ are independently hydrogen, fluorine or unsubstituted or fluorinated, straight, branched or cyclic alkyl groups of 1 to 20 carbon atoms; R⁸ and R⁹ are independently hydrogen, methyl or CH₂CO₂R¹¹; R¹⁰ is an unsubstituted or fluorinated, straight, branched or cyclic alkylene group of 1 to 20 carbon atoms; R¹¹ is a substituted or unsubstituted, straight, branched or cyclic alkyl group of 1 to 20 carbon atoms; and k is equal to 0 or 1.

The straight, branched or cyclic alkyl groups are those of 1 to 20 carbon atoms, preferably 1 to 12 carbon atoms, and more preferably 1 to 10 carbon atoms, including methyl, ethyl, propyl, isopropyl, n-butyl, sec-butyl, tert-butyl, cyclopentyl, cyclohexyl, 2-ethylhexyl, and n-octyl. The fluorinated alkyl groups correspond to the foregoing alkyl groups in which some, most or all hydrogen atoms are replaced by fluorine atoms and include, for example, trifluoromethyl, 2,2,2-trifluoroethyl, 3,3,3-trifluoropropyl, and 1,1,2,2,3,3,3-heptafluoropropyl. The substituted alkyl groups are typically the fluorinated alkyl groups described just above, though not limited thereto. Groups described as 'unsubstituted or fluorinated' may also be substituted, e.g. with other halogens, but this is not preferred. The alkylene groups of 1 to 20 carbon atoms and fluorinated alkylene groups of 1 to 20 carbon atoms correspond to the foregoing alkyl groups and fluorinated alkyl groups of 1 to 20 carbon atoms, with one hydrogen atom being eliminated therefrom, and they are preferably of 1 to 12 carbon atoms, and especially 1 to 10 carbon atoms.

Illustrative examples of the group of above formula (1) include groups of the following formulas (3-1) to (3-3).

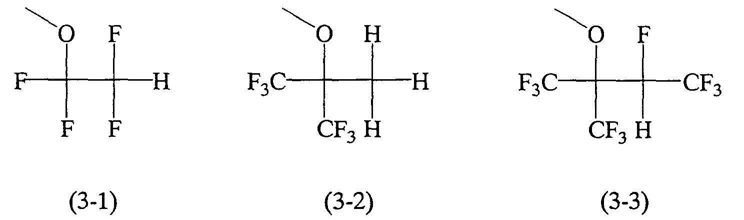

For the purpose of improving adhesion, recurring units of any of the following formulas (4) through (39) may be introduced into the inventive polymer in addition to the above-described units.

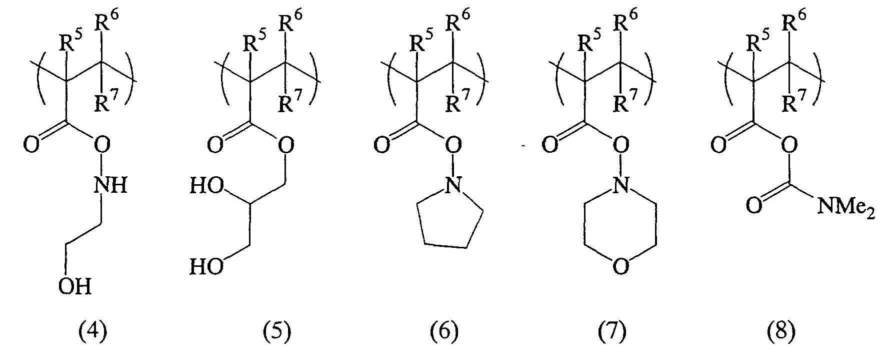

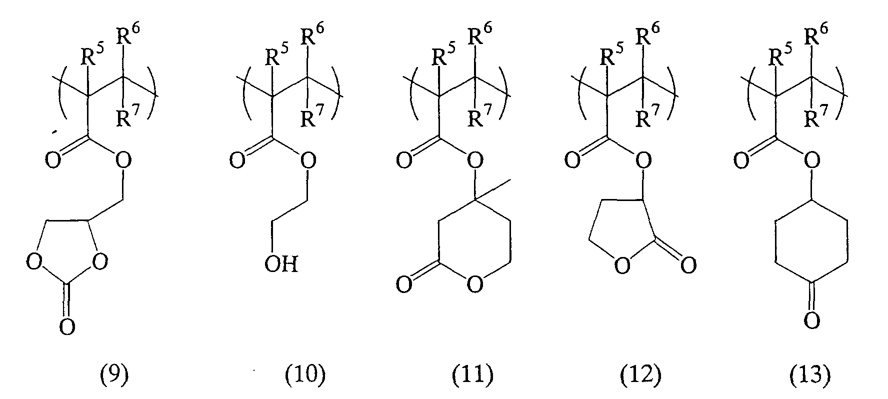

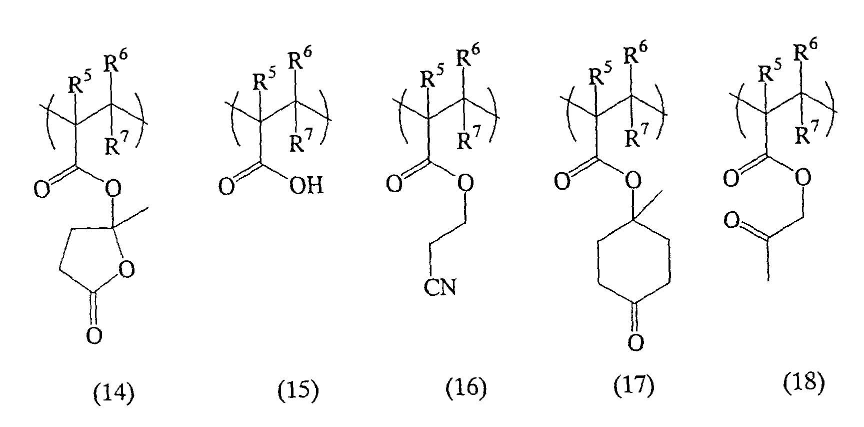

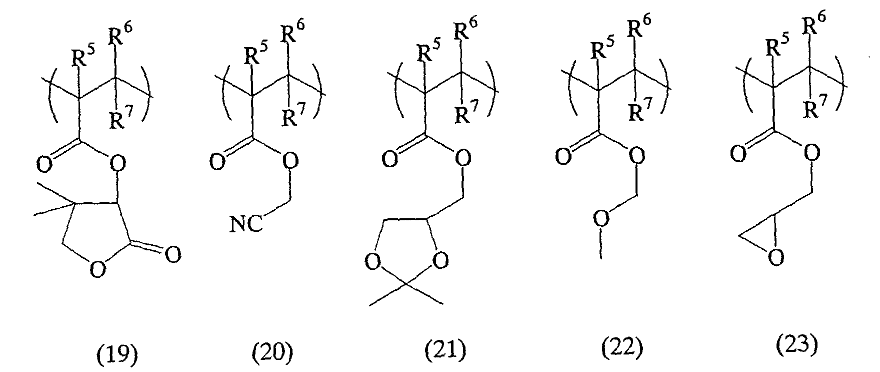

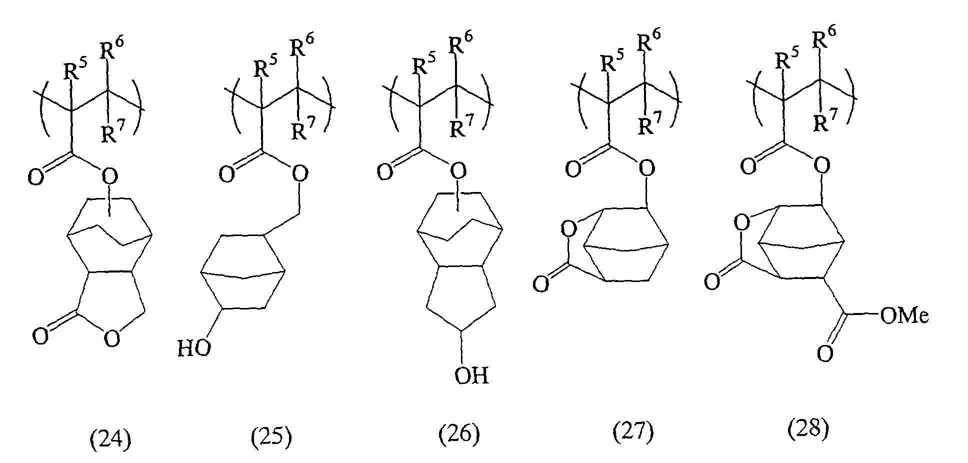

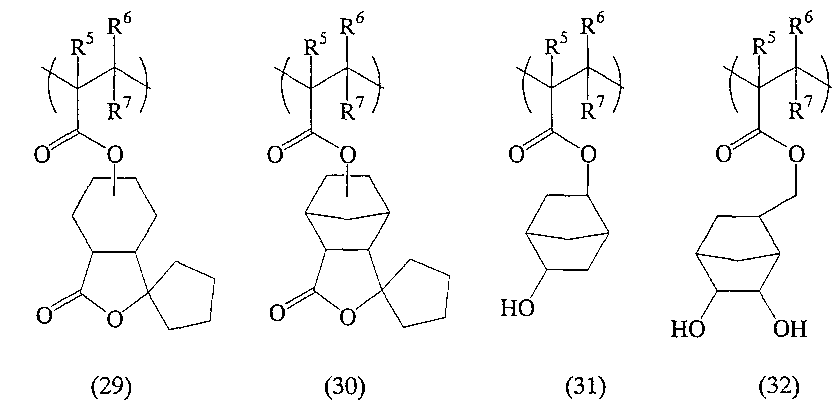

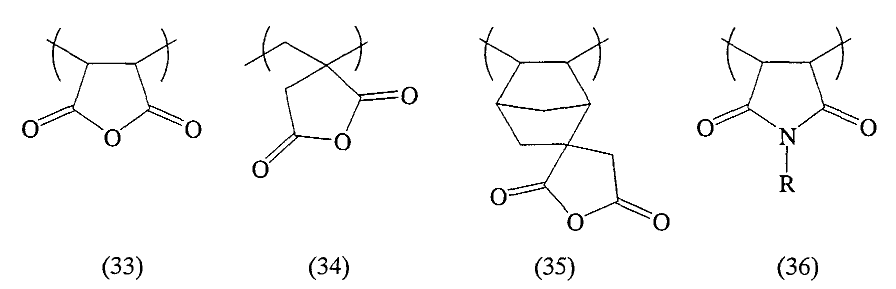

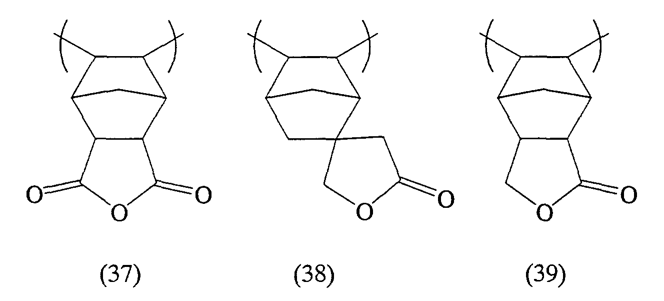

Herein, R⁵, R⁶ and R⁷ are as defined above.

Also, for contrast improving purposes, recurring units having fluorine-free acid labile groups, as shown by the following formulas (i) to (v), may be introduced into the inventive polymer.

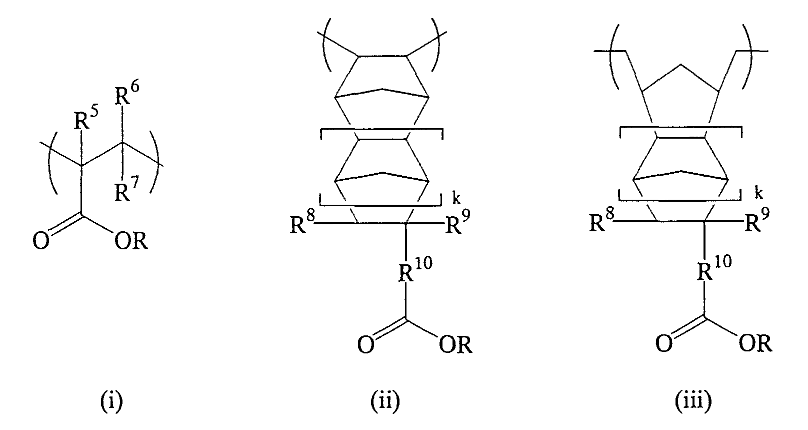

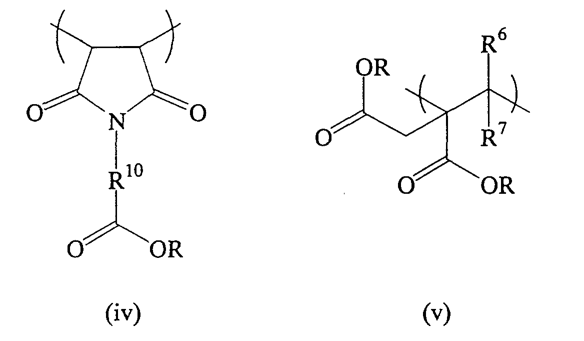

Herein, R⁵ to R¹⁰ and k are as defined above, R is an acid labile group.

The acid labile group represented by R is selected from a variety of such groups, preferably from among the groups of the following formulas (40) and (41), tertiary alkyl groups with 4 to 40 carbon atoms of the following formula (42), trialkylsilyl groups whose alkyl groups each have 1 to 6 carbon atoms, and oxoalkyl groups of 4 to 20 carbon atoms.

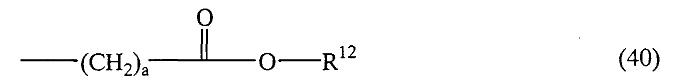

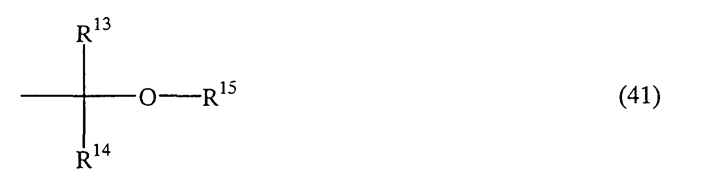

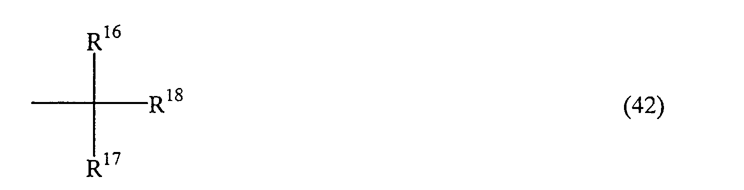

In formula (40), R¹² is a tertiary alkyl group of 4 to 20 carbon atoms, preferably 4 to 15 carbon atoms, a trialkylsilyl group whose alkyl groups each have 1 to 6 carbon atoms, an oxoalkyl group of 4 to 20 carbon atoms or a group of formula (42). Exemplary tertiary alkyl groups are tert-butyl, tert-amyl, 1,1-diethylpropyl, 1-ethylcyclopentyl, 1-butylcyclopentyl, 1-ethylcyclohexyl, 1-butylcyclohexyl, 1-ethyl-2-cyclopentenyl, 1-ethyl-2-cyclohexenyl, and 2-methyl-2-adamantyl. Exemplary trialkylsilyl groups are trimethylsilyl, triethylsilyl, and dimethyl-tert-butylsilyl. Exemplary oxoalkyl groups are 3-oxocyclohexyl, 4-methyl-2-oxooxan-4-yl, and 5-methyl-5-oxooxoran-4-yl. Letter "a" is an integer of 0 to 6.

In formula (41), R¹³ and R¹⁴ are independently hydrogen or straight, branched or cyclic alkyl groups of 1 to 18 carbon atoms, preferably 1 to 10 carbon atoms, for example, methyl, ethyl, propyl, isopropyl, n-butyl, sec-butyl, tert-butyl, cyclopentyl, cyclohexyl, 2-ethylhexyl and n-octyl. R15 is a monovalent hydrocarbon group of 1 to 18 carbon atoms, preferably 1 to 10 carbon atoms, which may have a hetero atom (e.g., oxygen atom), for example, straight, branched or cyclic alkyl groups, and such groups in which some hydrogen atoms are replaced by hydroxyl, alkoxy, oxo, amino or alkylamino groups. Illustrative examples of the substituted alkyl groups are given below.

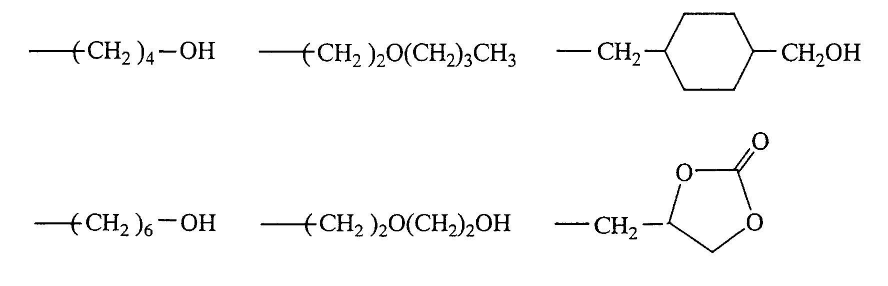

A pair of R¹³ and R¹⁴, a pair of R¹³ and R¹⁵, or a pair of R¹⁴ and R¹⁵, taken together, may form a ring. Each of R¹³, R¹⁴ and R¹⁵ is a straight or branched alkylene group of 1 to 18 carbon atoms, preferably 1 to 10 carbon atoms, when they form a ring.

Illustrative examples of the acid labile groups of formula (40) include tert-butoxycarbonyl, tert-butoxy-carbonylmethyl, tert-amyloxycarbonyl, tert-amyloxycarbonylmethyl, 1,1-diethylpropyloxycarbonyl, 1,1-diethylpropyloxycarbonylmethyl, 1-ethylcyclopentyloxycarbonyl, 1-ethylcyclopentyloxycarbonylmethyl, 1-ethyl-2-cyclopentenyloxycarbonyl, 1-ethyl-2-cyclopentenyloxycarbonylmethyl, 1-ethoxyethoxycarbonylmethyl, 2-tetrahydropyranyloxycarbonylmethyl, and 2-tetrahydrofuranyloxycarbonylmethyl.

Of the acid labile groups of formula (41), illustrative examples of the straight or branched groups are given below.
―CH₂―O―CH₃ ―CH₂―O―CH₂―CH₃ ―CH₂―O―(CH₂)₂―CH₃

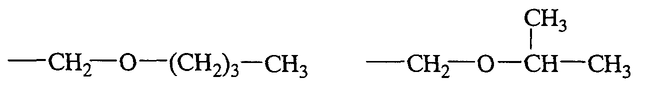

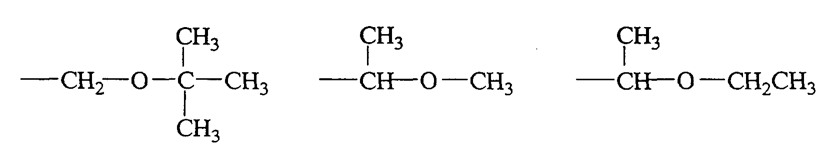

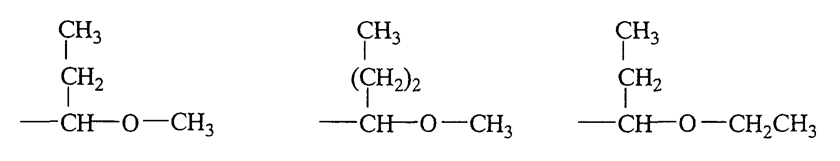

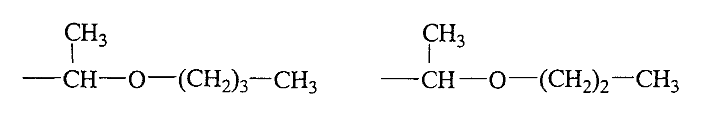

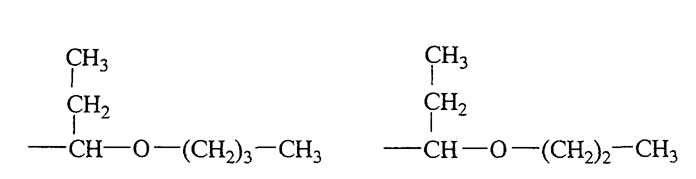

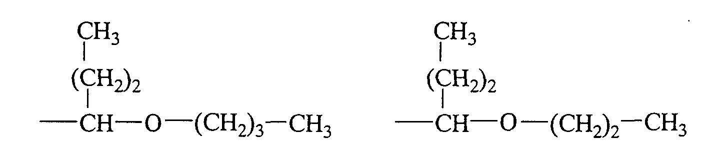

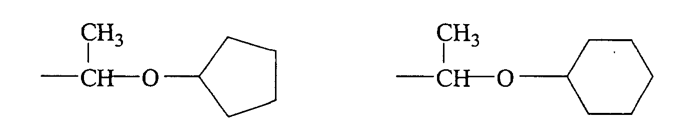

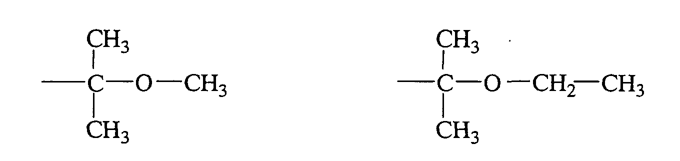

Of the acid labile groups of formula (41), illustrative examples of the cyclic groups include tetrahydrofuran-2-yl, 2-methyltetrahydrofuran-2-yl, tetrahydropyran-2-yl and 2-methyltetrahydropyran-2-yl. Preferred among the groups of formula (41) are ethoxyethyl, butoxyethyl and ethoxypropyl.

In formula (42), R¹⁶, R¹⁷ and R¹⁸ are independently monovalent hydrocarbon groups, for example, straight, branched or cyclic alkyl groups of 1 to 20 carbon atoms, which may contain a hetero atom such as oxygen, sulfur, nitrogen or fluorine. A pair of R¹⁶ and R¹⁷, a pair of R¹⁶ and R¹⁸, or a pair of R¹⁷ and R¹⁸, taken together, may form a ring.

Examples of the tertiary alkyl group represented by formula (42) include tert-butyl, triethylcarbyl, 1-ethylnorbornyl, 1-methylcyclohexyl, 1-ethylcyclopentyl, 2-(2-methyl)adamantyl, 2-(2-ethyl)adamantyl, and tert-amyl.

Other illustrative examples of the tertiary alkyl group are given below as formulae (43) through (58).

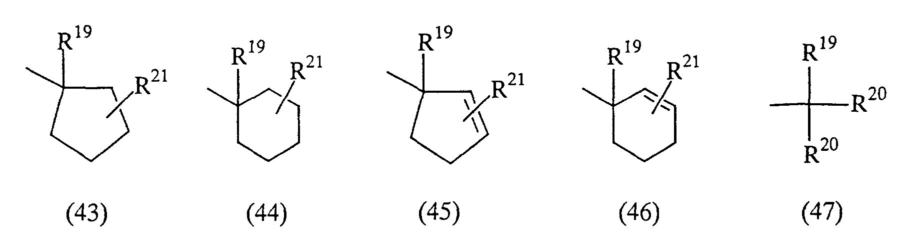

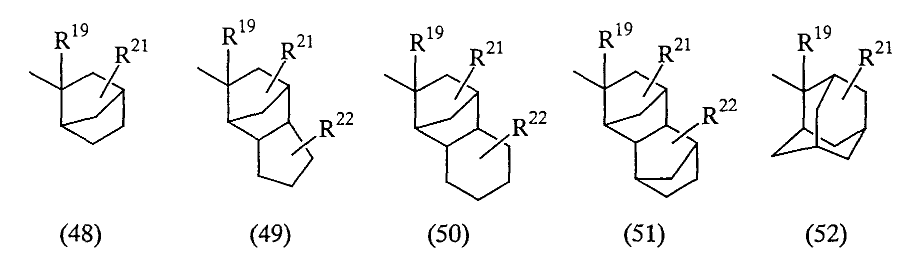

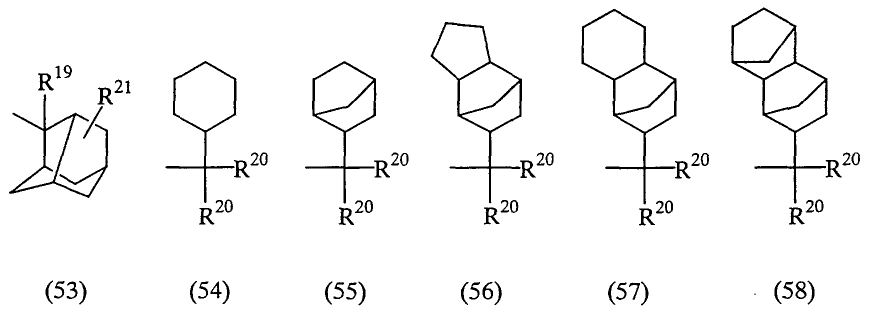

Herein, R¹⁹ is a straight, branched or cyclic alkyl group of 1 to 6 carbon atoms, for example, methyl, ethyl, propyl, isopropyl, n-butyl, sec-butyl, n-pentyl, n-hexyl, cyclopropyl, cyclopropylmethyl, cyclobutyl, cyclopentyl or cyclohexyl. R²⁰ is a straight, branched or cyclic alkyl group of 2 to 6 carbon atoms, for example, ethyl, propyl, isopropyl, n-butyl, sec-butyl, n-pentyl, n-hexyl, cyclopropyl, cyclopropylmethyl, cyclobutyl, cyclopentyl or cyclohexyl. R²¹ is hydrogen, a monovalent hydrocarbon group of 1 to 6 carbon atoms which may contain a hetero atom, or a monovalent hydrocarbon group of 1 to 6 carbon atoms which may be separated by a hetero atom. The hetero atom is an oxygen, sulfur or nitrogen atom, which is contained or intervenes in the form of -OH, -OR, -O-, -S-, -S(=O)-, -NH₂, -NHR, -NR₂, -NH-, or -NR- wherein R is an alkyl group of 1 to 20 carbon atoms, and especially 1 to 16 carbon atoms. R²² is hydrogen or an alkyl, hydroxyalkyl, alkoxy or alkoxyalkyl group of 1 to 20 carbon atoms, especially 1 to 16 carbon atoms, which may be straight, branched or cyclic. Illustrative examples include methyl, hydroxymethyl, ethyl, hydroxyethyl, propyl, isopropyl, n-butyl, sec-butyl, n-pentyl, n-hexyl, methoxy, methoxymethoxy, ethoxy, and tert-butoxy.

Of the acid labile group represented by R, the trialkylsilyl groups whose alkyl groups each have 1 to 6 carbon atoms include trimethylsilyl, triethylsilyl, and tert-butyldimethylsilyl.

The oxoalkyl groups of 4 to 20 carbon atoms include 3-oxocyclohexyl and similar groups.

The polymer of the invention may be prepared using an essential monomer having a carbon-to-carbon double bond and a group of formula (1) and optionally, other monomer e.g. to provide units of one of formulas (4) to (39) and/or additional monomer to provide units of one or more of formulas (i) to (v). Illustratively, an essential monomer usable herein is a monomer to provide recurring units of one of formulas (2-1) to (2-5), for example, a monomer of the following formula to provide recurrinq units of formula (2-1).

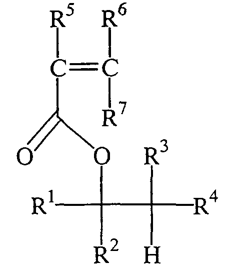

The polymer or high molecular weight compound is generally prepared by mixing the above-mentioned essential monomer and optional monomers with a solvent, adding a catalyst thereto, and effecting polymerization reaction while heating or cooling the system if necessary. The polymerization reaction depends on the type of initiator or catalyst, trigger means (including light, heat, radiation and plasma), and polymerization conditions (including temperature, pressure, concentration, solvent, and additives). Commonly used for the polymerization of the monomer are radical polymerization of triggering polymerization with radicals of α,α'-azobisisobutyronitrile (AIBN) or the like, and ion (anion) polymerization using catalysts such as alkyl lithium. Such polymerization may be effected in a conventional manner.

Provided that A denotes units having a group of formula (1), B denotes units of formulas (4) to (39) and C denotes units of formulas (i) to (v), a preferred polymer is representable by the following formula.

(A)ₐ(B)_{b}(C)_{c}

Herein, "a" is a positive number, and "b" and "c" are 0 or positive numbers, and preferably satisfy the following range.
0.1 ≤ a/(a+b+c) ≤ 0.8, especially 0.3 ≤ a/(a+b+c) ≤ 0.6
0 ≤ b/(a+b+c) ≤ 0.8, especially 0.1 ≤ b/(a+b+c) ≤ 0.6
0 s c/(a+b+c) ≤ 0.5, especially 0 ≤ c/(a+b+c) ≤ 0.3

The polymer of the invention preferably has a weight average molecular weight of about 1,000 to 1,000,000, and especially about 2,000 to 100,000.

The polymer of the invention is useful as a base resin in resist compositions, typically chemical amplification type resist compositions, and especially chemical amplification type positive resist compositions.

### Resist composition

A second aspect of the invention is a resist composition comprising the polymer defined above.

In one preferred embodiment, the invention provides a chemical amplification positive resist composition comprising (A) the polymer defined above as a base resin, (B) an organic solvent, and (C) a photoacid generator.

The resist composition may further contain (D) a basic compound and/or (E) a dissolution inhibitor.

### Component (B)

The organic solvent used as component (B) in the invention may be any organic solvent in which the photoacid generator, base resin (inventive polymer), dissolution inhibitor, and other components are soluble. Illustrative, non-limiting, examples of the organic solvent include ketones such as cyclohexanone and methyl-2-n-amylketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate.

Also useful are fluorinated organic solvents. Examples include 2-fluoroanisole, 3-fluoroanisole, 4-fluoroanisole, 2,3-difluoroanisole, 2,4-difluoroanisole, 2,5-difluoroanisole, 5,8-difluoro-1,4-benzodioxane, 2,3-difluorobenzyl alcohol, 1,3-difluoro-2-propanol, 2',4'-difluoropropiophenone, 2,4-difluorotoluene, trifluoro-acetaldehyde ethyl hemiacetal, trifluoroacetamide, trifluoroethanol, 2,2,2-trifluoroethyl butyrate, ethyl heptafluorobutyrate, ethyl heptafluorobutylacetate, ethyl hexafluoroglutarylmethyl, ethyl 3-hydroxy-4,4,4-trifluorobutyrate, ethyl 2-methyl-4,4,4-trifluoroacetoacetate, ethyl pentafluorobenzoate, ethyl pentafluoropropionate, ethyl pentafluoropropynylacetate, ethyl perfluorooctanoate, ethyl 4,4,4-trifluoroacetoacetate, ethyl 4,4,4-trifluorobutyrate, ethyl 4,4,4-trifluorocrotonate, ethyl trifluorosulfonate, ethyl 3-(trifluoromethyl)butyrate, ethyl trifluoropyruvate, S-ethyl trifluoroacetate, fluorocyclohexane, 2,2,3,3,4,4,4-heptafluoro-1-butanol, 1,1,1,2,2,3,3-heptafluoro-7,7-dimethyl-4,6-octanedione, 1,1,1,3,5,5,5-heptafluoropentane-2,4-dione, 3,3,4,4,5,5,5-heptafluoro-2-pentanol, 3,3,4,4,5,5,5-heptafluoro-2-pentanone, isopropyl 4,4,4-trifluoroacetoacetate, methyl perfluorodecanoate, methyl perfluoro(2-methyl-3-oxahexanoate), methyl perfluorononanoate, methyl perfluorooctanoate, methyl 2,3;3,3-tetrafluoropropionate, methyl trifluoroacetoacetate, 1,1,1,2,2,6,6,6-octafluoro-2,4-hexanedione, 2,2,3,3,4,4,5,5-octafluoro-1-pentanol, 1H, 1H, 2H, 2H-perfluoro-1-decanol, perfluoro-2,5-dimethyl-3,6-dioxane anionic acid methyl ester, 2H-perfluoro-5-methyl-3,6-dioxanonane, 1H, 1H, 2H, 3H, 3H-perfluorononane-1,2-diol, 1H, 1H, 9H-perfluoro-1-nonanol, 1H, 1H-perfluorooctanol, 1H, 1H, 2H, 2H-perfluorooctanol, 2H-perfluoro-5,8,11,14-tetramethyl-3,6,9,12,15-pentaoxaoctadecane, perfluorotributylamine, perfluorotrihexylamine, methyl perfluoro-2,5,8-trimethyl-3,6,9-trioxadodecanoate, perfluorotripentylamine, perfluorotripropylamine, 1H, 1H,2H, 3H,3H-perfluoroundecane-1,2-diol, trifluorobutanol-1,1,1-trifluoro-5-methyl-2,4-hexanedione, 1,1,1-trifluoro-2-propanol, 3,3,3-trifluoro-1-propanol, 1,1,1-trifluoro-2-propyl acetate, perfluoro-butyltetrahydrofuran, perfluoro(butyltetrahydrofuran), perfluorodecalin, perfluoro(1,2-dimethylcyclohexane), perfluoro(1,3-dimethylcyclohexane), propylene glycol trifluoromethyl ether acetate, propylene glycol methyl ether trifluoromethyl acetate, butyl trifluoromethylacetate, methyl 3-trifluoromethoxypropionate, perfluorocyclohexanone, propylene glycol trifluoromethyl ether, butyl trifluoroacetate, and 1,1,1-trifluoro-5,5-dimethyl-2,4-hexanedione. These solvents may be used alone or in combinations of two or more thereof.

Of the above organic solvents, preferred are diethylene glycol dimethyl ether and 1-ethoxy-2-propanol, in which the photoacid generator is most soluble, and propylene glycol monomethyl ether acetate which is safe, and mixtures thereof.

The organic solvent is typically used in an amount of about 200 to 5,000 parts by weight per 100 parts by weight of the base resin.

### Component (C)

Suitable examples of the photoacid generator (C) include onium salts of general formula (59) below, diazomethane derivatives of formula (60), glyoxime derivatives of formula (61), β-ketosulfone derivatives, disulfone derivatives, nitrobenzylsulfonate derivatives, sulfonic acid ester derivatives, and imidoyl sulfonate derivatives.

(R²³)ₘM⁺K⁻ (59)

In the formula, R²³ is a straight, branched or cyclic alkyl of 1 to 12 carbon atoms, an aryl of 6 to 12 carbon atoms, or an aralkyl of 7 to 12 carbon atoms; M⁺ is iodonium or sulfonium; K⁻ is a non-nucleophilic counter-ion; and the letter m is 2 or 3.

Illustrative examples of alkyl groups represented by R²³ include methyl, ethyl, propyl, butyl, pentyl, 2-oxocyclohexyl, norbornyl, and adamantyl. Exemplary aryl groups include phenyl; alkoxyphenyl groups such as p-methoxyphenyl, m-methoxyphenyl, o-methoxyphenyl, ethoxyphenyl, p-tert-butoxyphenyl, and m-tert-butoxyphenyl; and alkylphenyl groups such as 2-methylphenyl, 3-methylphenyl, 4-methylphenyl, ethylphenyl, 4-tert-butylphenyl, 4-butylphenyl, and dimethylphenyl. Exemplary aralkyl groups include benzyl and phenethyl. Examples of the non-nucleophilic counter-ion represented by K⁻ include halide ions such as chloride and bromide; fluoroalkylsulfonate ions such as triflate, 1,1,1-trifluoroethanesulfonate, and nonafluorobutanesulfonate; arylsulfonate ions such as tosylate, benzenesulfonate, 4-fluorobenzenesulfonate, and 1,2,3,4,5-pentafluorobenzenesulfonate; and alkylsulfonate ions such as mesylate and butanesulfonate.

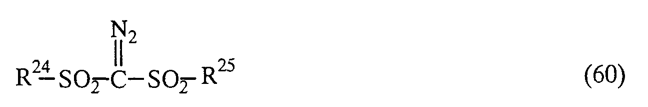

In the formula, R²⁴ and R²⁵ are straight, branched or cyclic alkyl or halogenated alkyl groups of 1 to 12 carbon atoms, aryl or halogenated aryl groups of 6 to 12 carbon atoms, or aralkyl groups of 7 to 12 carbon atoms.

Illustrative examples of alkyl groups represented by R²⁴ and R²⁵ include methyl, ethyl, propyl, butyl, amyl, cyclopentyl, cyclohexyl, norbornyl, and adamantyl. Exemplary halogenated alkyl groups include trifluoromethyl, 1,1,1-trifluoroethyl, 1,1,1-trichloroethyl, and nonafluorobutyl. Exemplary aryl groups include phenyl; alkoxyphenyl groups such as p-methoxyphenyl, m-methoxyphenyl, o-methoxy-phenyl, ethoxyphenyl, p-tert-butoxyphenyl, and m-tert-butoxyphenyl; and alkylphenyl groups such as 2-methylphenyl, 3-methylphenyl, 4-methylphenyl, ethylphenyl, 4-tert-butylphenyl, 4-butylphenyl, and dimethylphenyl. Exemplary halogenated aryl groups include fluorophenyl, chlorophenyl, and 1,2,3,4,5-pentafluorophenyl. Exemplary aralkyl groups include benzyl and phenethyl.

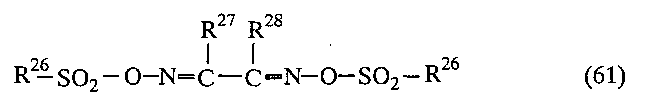

In the formula, R²⁶, R²⁷, and R²⁸ are straight, branched or cyclic alkyl or halogenated alkyl groups of 1 to 12 carbon atoms, aryl or halogenated aryl groups of 6 to 12 carbon atoms, or aralkyl groups of 7 to 12 carbon atoms. R²⁷ and R²⁸ may together form a cyclic structure with the proviso that if they form a cyclic structure, each is a straight or branched alkylene group of 1 to 6 carbon atoms.

The alkyl, halogenated alkyl, aryl, halogenated aryl, and aralkyl groups represented by R²⁶, R²⁷, and R²⁸ are exemplified by the same groups as mentioned above for R²⁴ and R²⁵. Examples of alkylene groups represented by R²⁷ and R²⁸ include methylene, ethylene, propylene, butylene, and hexylene.

Illustrative examples of the photoacid generator include:
onium salts such as diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butqxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, ethylene bis[methyl(2-oxocyclopentyl)sulfonium trifluoromethanesulfonate], and 1,2'-naphthylcarbonylmethyltetrahydrothiophenium triflate;
diazomethane derivatives such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, and 1-tert-amylsulfonyl-1-(tert-butylsulfonyl)diazomethane;
glyoxime derivatives such as bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-o-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluoro-octanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime;
β-ketosulfone derivatives such as 2-cyclohexylcarbonyl-2-(p-toluenesulfonyl)propane and 2-isopropyl-carbonyl-2-(p-toluenesulfonyl)propane;
disulfone derivatives such as diphenyl disulfone and dicyclohexyl disulfone;
nitrobenzyl sulfonate derivatives such as 2,6-dinitrobenzyl p-toluenesulfonate and 2,4-dinitrobenzyl p-toluenesulfonate;
sulfonic acid ester derivatives such as 1,2,3-tris(methanesulfonyloxy)benzene, 1,2,3-tris(trifluoromethanesulfonyloxy)benzene, and 1,2,3-tris(p-toluene-sulfonyloxy)benzene; and
imidoyl sulfonate derivatives such as phthalimidoyl triflate, phthalimidoyl tosylate, 5-norbornene-2,3-dicarboxyimidoyl triflate, 5-norbornene-2,3-dicarboxyimidoyl tosylate, and 5-norbornene-2,3-dicarboxyimidoyl butylsulfonate.

Preferred among these photoacid generators are onium salts such as triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, tris(p-tert-butoxyphenyl)sulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, and 1,2'-naphthylcarbonylmethyl-tetrahydrothiophenium triflate; diazomethane derivatives such as bis(benzenesulfonyl)diazomethane, bis(p-toluenesulfonyl)diazomethane, bis(cyclohexylsulfonyl)-diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, and bis(tert-butyl-sulfonyl)diazomethane; and glyoxime derivatives such as bis-o-(p-toluenesulfonyl)-α-dimethylglyoxime and bis-o-(n-butanesulfonyl)-α-dimethylglyoxime. These photoacid generators may be used singly or in combinations of two or more thereof. Onium salts are effective for improving rectangularity, while diazomethane derivatives and glyoxime derivatives are effective for reducing standing waves. The combination of an onium salt with a diazomethane or a glyoxime derivative allows for fine adjustment of the profile.

The photoacid generator is preferably added in an amount of about 0.2 to 15 parts by weight per 100 parts by weight of all the base resins. At less than 0.2 part, the amount of acid generated during exposure would be too small and the sensitivity and resolution be poor, whereas the addition of more than 15 parts would result in a lower transparency and a poor resolution.

### Component (D)

The basic compound used as component (D) is preferably a compound capable of suppressing the rate of diffusion when the acid generated by the photoacid generator diffuses within the resist film. The inclusion of this type of basic compound holds down the rate of acid diffusion within the resist film, resulting in better resolution. In addition, it suppresses changes in sensitivity following exposure, thus reducing substrate and environment dependence, as well as improving the exposure latitude and the pattern profile. See JP-A 5-232706, 5-249683, 5-158239, 5-249662, 5-257282, 5-289322, and 5-289340.

Examples of suitable basic compounds include primary, secondary, and tertiary aliphatic amines, mixed amines, aromatic amines, heterocyclic amines, carboxyl group-bearing nitrogenous compounds, sulfonyl group-bearing nitrogenous compounds, hydroxyl group-bearing nitrogenous compounds, hydroxyphenyl group-bearing nitrogenous compounds, alcoholic nitrogenous compounds, amide derivatives, and imide derivatives.

Examples of suitable primary aliphatic amines include ammonia, methylamine, ethylamine, n-propylamine, isopropylamine, n-butylamine, iso-butylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine. Examples of suitable secondary aliphatic amines include dimethylamine, diethylamine, di-n-propylamine, di-iso-propylamine, di-n-butylamine, di-iso-butylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Examples of suitable tertiary aliphatic amines include trimethylamine, triethylamine, tri-n-propylamine, tri-iso-propylamine, tri-n-butylamine, tri-iso-butylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyl-tetraethylenepentamine.

Examples of suitable mixed amines include dimethylethylamine, methylethylpropylamine, benzylamine, phenethylamine, and benzyldimethylamine. Examples of suitable aromatic and heterocyclic amines include aniline derivatives (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, and N,N-dimethyltoluidine), diphenyl(p-tolyl)amine, methyldiphenylamine, triphenylamine, phenylenediamine, naphthylamine, diaminonaphthalene, pyrrole derivatives (e.g., pyrrole, 2H-pyrrole, 1-methylpyrrole, 2,4-dimethylpyrrole, 2,5-dimethylpyrrole, and N-methylpyrrole), oxazole derivatives (e.g., oxazole and isooxazole), thiazole derivatives (e.g., thiazole and isothiazole), imidazole derivatives (e.g., imidazole, 4-methylimidazole, and 4-methyl-2-phenylimidazole), pyrazole derivatives, furazan derivatives, pyrroline derivatives (e.g., pyrroline and 2-methyl-1-pyrroline), pyrrolidine derivatives (e.g., pyrrolidine, N-methylpyrrolidine, pyrrolidinone, and N-methylpyrrolidone), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline and 3-quinolinecarbonitrile), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Examples of suitable carboxyl group-bearing nitrogenous compounds include aminobenzoic acid, indolecarboxylic acid, and amino acid derivatives (e.g. nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of suitable sulfonyl group-bearing nitrogenous compounds include 3-pyridinesulfonic acid and pyridinium p-toluenesulfonate. Examples of suitable hydroxyl group-bearing nitrogenous compounds, hydroxyphenyl group-bearing nitrogenous compounds, and alcoholic nitrogenous compounds include 2-hydroxypyridine, aminocresol, 2,4-quinolinediol, 3-indolemethanol hydrate, monoethanolamine, diethanolamine, triethanolamine, N-ethyldiethanolamine, N,N-diethyl-ethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, and N-(2-hydroxyethyl)isonicotinamide. Examples of suitable amide derivatives include formamide, N-methylformamide, N,N-dimethylformamide, acetamide, N-methylacetamide, N,N-dimethylacetamide, propionamide, and benzamide. Suitable imide derivatives include phthalimide, succinimide, and maleimide.

In addition, basic compounds of the following general formulas (62) and (63) may also be included.

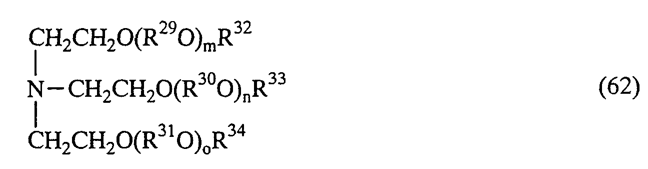

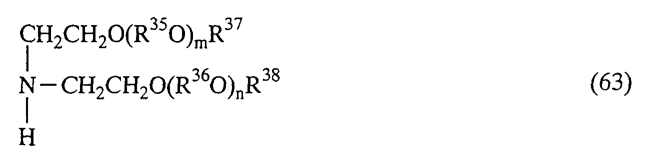

In the formulas, R²⁹, R³⁰, R³¹, R³⁵ and R³⁶ are independently straight, branched or cyclic alkylenes of 1 to 20 carbon atoms; R³², R³³, R³⁴, R³⁷ and R³⁸ are hydrogen, alkyls of 1 to 20 carbon atoms, or amino; R³² and R³³, R³³ and R³⁴, R³² and R³⁴, R³² with R³³ and R³⁴, and R³⁷ and R³⁸ may bond together to form rings; and m, n and o are each integers from 0 to 20, with the proviso that hydrogen is excluded from R²⁹, R³⁰, R³¹, R³⁵ and R³⁶ when m, n and o are equal to 0. Or, when m, n and o are all 0, not all of R^{29,30,31,35,36} are H.

The alkylene groups represented by R²⁹, R³⁰, R³¹, R³⁵ and R³⁶ preferably have 1 to 20 carbon atoms, more preferably 1 to 10 carbon atoms, and most preferably 1 to 8 carbon atoms. Examples include methylene, ethylene, n-propylene, isopropylene, n-butylene, isobutylene, n-pentylene, isopentylene, hexylene, nonylene, decylene, cyclopentylene, and cyclohexylene.

The alkyl groups represented by R³², R³³, R³⁴, R³⁷ and R³⁸ preferably have 1 to 20 carbon atoms, more preferably 1 to 8 carbon atoms, and most preferably 1 to 6 carbon atoms, and may be straight, branched or cyclic. Examples include methyl, ethyl, n-propyl, isopropyl, n-butyl, isobutyl, tert-butyl, n-pentyl, isopentyl, hexyl, nonyl, decyl, dodecyl, tridecyl, cyclopentyl, and cyclohexyl.

Where R³² and R³³, R³³ and R³⁴, R³² and R³⁴, R³² with R³³ and R³⁴, and R³⁷ and R³⁸ form rings, the rings preferably have 1 to 20 carbon atoms, more preferably 1 to 8 carbon atoms, and most preferably 1 to 6 carbon atoms, and may have branching alkyl groups of 1 to 6 carbon atoms, and especially 1 to 4 carbon atoms.

The letters m, n, and o are each integers from 0 to 20, preferably from 1 to 10, and more preferably from 1 to 8.

Illustrative examples of the compounds of formulas (62) and (63) include tris{2-(methoxymethoxy)ethyl}amine, tris{2-(methoxyethoxy)ethyl)amine, tris[2-{(2-methoxy-ethoxy)methoxy}ethyl]amine, tris{2-(2-methoxyethoxy)ethyl}amine, tris{2-(1-methoxyethoxy)ethyl}amine, tris{2-(1-ethoxyethoxy)ethyl}amine, tris{2-(1-ethoxypropoxy)ethyl}amine, tris[2-{(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, and 1-aza-18-crown-6. Especially preferred basic compounds are tertiary amines, aniline derivatives, pyrrolidine derivatives, pyridine derivatives, quinoline derivatives, amino acid derivatives, hydroxyl group-bearing nitrogenous compounds, hydroxyphenyl group-bearing nitrogenous compounds, alcoholic nitrogenous compounds, amide derivatives, imide derivatives, tris{2-(methoxymethoxy)ethyl}amine, tris{2-(2-methoxyethoxy)ethyl}amine, tris[2-{(2-methoxyethoxy)methyl}ethyl]amine, and 1-aza-15-crown-5.

The above-described basic compound may be used singly or in combinations of two or more thereof, and is preferably formulated in an amount of about 0.01 to 2 parts, and especially about 0.01 to 1 part by weight, per 100 parts by weight of the base resin. At less than 0.01 part, the desired effects of the basic compound would not be apparent, while the use of more than 2 parts may result in too low a resolution or sensitivity.

### Component (E)

The dissolution inhibitor (E) is a compound with a molecular weight of up to 3,000 which changes its solubility in an alkaline developer under the action of an acid. Typically, a compound obtained by partially or entirely substituting acid labile substituents on a phenol or carboxylic acid derivative having a molecular weight of up to 2,500 is added as the dissolution inhibitor. The acid labile groups used herein may be either fluorinated acid labile groups as previously mentioned or customary fluorine-free acid labile groups.

Examples of the phenol or carboxylic acid derivative having a molecular weight of up to 2,500 include 4,4'-(1-methylethylidene)bisphenol, (1,1'-biphenyl-4,4'-diol)-2,2'-methylenebis(4-methylphenol), 4,4-bis(4'-hydroxyphenyl)valeric acid, tris(4-hydroxyphenyl)methane, 1,1,1-tris(4'-hydroxyphenyl)ethane, 1,1,2-tris(4'-hydroxyphenyl)ethane, phenolphthalein, thimolphthalein, 3,3'-difluoro[(1,1'-biphenyl)-4,4'-diol], 3,3',5,5'-tetrafluoro[(1,1'-biphenyl)-4,4'-diol], 4,4'-[2,2,2-trifluoro-1-(trifluoromethyl)ethylidene]bisphenol, 4,4'-methylenebis(2-fluorophenol), 2,2'-methylenebis(4-fluorophenol), 4,4'-isopropylidenebis(2-fluorophenol), cyclohexylidenebis(2-fluorophenol), 4,4'-[(4-fluorophenyl)methylene]bis(2-fluorophenol), 4,4'-methylenebis(2,6-difluorophenol), 4,4'-(4-fluorophenyl)methylenebis(2,6-difluorophenol), 2,6-bis[(2-hydroxy-5-fluorophenyl)methyl]-4-fluorophenol, 2,6-bis[(4-hydroxy-3-fluorophenyl)methyl]-4-fluorophenol, and 2,4-bis[(3-hydroxy-4-hydroxyphenyl)methyl]-6-methylphenol. The acid labile substituents are the same as illustrated above as formulas (40) to (42).

Illustrative, non-limiting, examples of the dissolution inhibitors which are useful herein include 3,3'-5,5'-tetrafluoro[(1,1'-biphenyl)-4,4'-di-t-butoxycarbonyl], 4,4'-[2,2,2-trifluoro-1-(trifluoromethyl)ethylidene]bisphenol-4,4'-di-t-butoxycarbonyl, bis(4-(2'-tetrahydropyranyloxy)phenyl)methane, bis(4-(2'-tetrahydrofuranyloxy)phenyl)methane, bis(4-tert-butoxyphenyl)methane, bis(4-tert-butoxycarbonyloxyphenyl)methane, bis(4-tert-butoxycarbonylmethyloxyphenyl)methane, bis(4-(1'-ethoxy-ethoxy)phenyl)methane, bis(4-(1'-ethoxypropyloxy)phenyl)methane, 2,2-bis(4'-(2"-tetrahydropyranyloxy))propane, 2,2-bis(4'-(2"-tetrahydrofuranyloxy)phenyl)propane, 2,2-bis(4'-tert-butoxyphenyl)propane, 2,2-bis(4'-tert-butoxycarbonyloxyphenyl)propane, 2,2-bis(4-tert-butoxy-carbonylmethyloxyphenyl)propane, 2,2-bis(4'-(1"-ethoxy-ethoxy)phenyl)propane, 2,2-bis(4'-(1"-ethoxypropyloxy)-phenyl)propane, tert-butyl 4,4-bis(4'-(2"-tetrahydropyranyloxy)phenyl)valerate, tert-butyl 4,4-bis(4'-(2"-tetrahydrofuranyloxy)phenyl)valerate, tert-butyl 4,4-bis(4'-tert-butoxyphenyl)valerate, tert-butyl 4,4-bis(4-tert-butoxycarbonyloxyphenyl)valerate, tert-butyl 4,4-bis(4'-tert-butoxycarbonylmethyloxyphenyl)valerate, tert-butyl 4,4-bis(4'-(1"-ethoxyethoxy)phenyl)valerate, tert-butyl 4,4-bis(4'-(1"-ethoxypropyloxy)phenyl)valerate, tris(4-(2'-tetrahydropyranyloxy)phenyl)methane, tris(4-(2'-tetrahydrofuranyloxy)phenyl)methane, tris(4-tert-butoxyphenyl)methane, tris(4-tert-butoxycarbonyloxyphenyl)methane, tris(4-tert-butoxycarbonyloxymethylphenyl)methane, tris(4-(1'-ethoxyethoxy)phenyl)methane, tris(4-(1'-ethoxypropyloxy)phenyl)methane, 1,1,2-tris(4'-(2"-tetrahydropyranyloxy)phenyl)ethane, 1,1,2-tris(4'-(2"-tetrahydrofuranyloxy)phenyl)ethane, 1,1,2-tris(4'-tert-butoxyphenyl)ethane, 1,1,2-tris(4'-tert-butoxycarbonyl-oxyphenyl)ethane, 1,1,2-tris(4'-tert-butoxycarbonylmethyl-oxyphenyl)ethane, 1,1,2-tris(4'-(1'-ethoxyethoxy)phenyl)ethane, 1,1,2-tris(4'-(1'-ethoxypropyloxy)phenyl)ethane, t-butyl 2-trifluoromethylbenzenecarboxylate, t-butyl 2-trifluoromethylcyclohexanecarboxylate, t-butyl decahydronaphthalene-2,6-dicarboxylate, t-butyl cholate, t-butyl deoxycholate, t-butyl adamantanecarboxylate, t-butyl adamantaneacetate, and tetra-t-butyl 1,1'-bicyclohexyl-3,3',4,4'-tetracarboxylate.

In the resist composition, usually an appropriate amount of the dissolution inhibitor (E) is up to about 20 parts, and especially up to about 15 parts by weight per 100 parts by weight of the solids in the composition. With more than 20 parts of the dissolution inhibitor, the resist composition becomes less heat resistant because of an increased content of monomer components.

The resist composition of the invention may include, as an optional ingredient, a surfactant which is commonly used for improving the coating characteristics. Optional ingredients may be added in conventional amounts so long as this does not compromise the properties of the material.

A nonionic surfactant is preferred, examples of which include perfluoroalkyl polyoxyethylene ethanols, fluorinated alkyl esters, perfluoroalkylamine oxides, perfluoroalkyl EO adducts, and fluorinated organosiloxane compounds. Illustrative examples include Florade FC-430 and FC-431 from Sumitomo 3M Ltd., Surflon S-141 and S-145 from Asahi Glass Co., Ltd., Unidyne DS-401, DS-403, and DS-451 from Daikin Industries Ltd., Megaface F-8151 from Dainippon Ink & Chemicals, Inc., and X-70-092 and X-70-093 from Shin-Etsu Chemical Co., Ltd. Preferred surfactants include Florade FC-430 from Sumitomo 3M Ltd. and X-70-093 from Shin-Etsu Chemical Co., Ltd.

Pattern formation using the resist composition of the invention may be carried out by a known lithographic technique. For example, the resist composition may be applied onto a substrate such as a silicon wafer by spin coating or the like to form a resist film having a thickness of 0.1 to 1.0 pm, which is then pre-baked on a hot plate at 60 to 200°C for 10 seconds to 10 minutes, and preferably at 80 to 150°C for 1/2 to 5 minutes. A patterning mask having the desired pattern may then be placed over the resist film, and the film exposed through the mask to an electron beam or to high-energy radiation such as deep-UV rays having a wavelength below 300 nm, an excimer laser, or x-rays in a dose of about 1 to 200 mJ/cm², and preferably about 10 to 100 mJ/cm², then post-exposure baked (PEB) on a hot plate at 60 to 150°C for 10 seconds to 5 minutes, and preferably at 80 to 130°C for 1/2 to 3 minutes. Finally, development may be carried out using as the developer an aqueous alkali solution, such as 0.1 to 5%, and preferably 2 to 3%, tetramethylammonium hydroxide (TMAH), this being done by a conventional method such as dipping, puddling, or spraying for a period of 10 seconds to 3 minutes, and preferably 30 seconds to 2 minutes. These steps result in the formation of the desired pattern on the substrate. Of the various types of high-energy radiation that may be used, the resist composition of the invention is best suited to micro-pattern formation with, in particular, deep-UV rays having a wavelength of 254 to 120 nm, an excimer laser, especially ArF excimer laser (193 nm), F₂ excimer laser (157 nm), Kr₂ excimer laser (146 nm), KrAr excimer laser (134 nm) or Ar₂ excimer laser (121 nm), x-rays, or an electron beam. The desired pattern may not be obtainable outside the upper and lower limits of the above range.

Using these polymers, we have been able to prepare resist compositions sensitive to high-energy radiation, with excellent sensitivity and resolution at a wavelength of less than 200 nm, especially less than 170 nm, and excellent plasma etching resistance while the progress of negative conversion is restrained. Because these features of the present resist composition enable its use particularly as a resist having a low absorption at the exposure wavelength of a F₂ excimer laser, a finely defined pattern having sidewalls perpendicular to the substrate can easily be formed, making the resist ideal as a micropatterning material in VLSI fabrication.

### EXAMPLE

Examples of the invention are given below by way of illustration and not by way of limitation. The abbreviations used herein are THF for tetrahydrofuran, AIBN for α,α'-azobisisobutyronitrile, GPC for gel permeation chromatography, Mw for weight average molecular weight, and Mn for number average molecular weight.

### Synthesis Example 1-1

### Synthesis of 1,1-bis(trifluoromethyl)ethyl methacrylate

In a 500-ml flask, 100 ml of THF was cooled to -78°C, in which 25 g of hexafluoroacetone was dissolved. To the solution, 160 ml of a THF solution of 1.0M methyl lithium was added dropwise, followed by 2 hours of ripening. Methacrylic chloride, 17.5 g, was added dropwise, followed by 2 hours of ripening. The reaction solution was post treated in a conventional manner. The resulting oily substance was distilled in vacuum, collecting 28.3 g of 1,1-bis(trifluoromethyl)ethyl methacrylate. The yield was 75%.

### Synthesis Example 1-2

### Synthesis of 1,1-bis(heptafluoroisopropyl)ethyl methacrylate

In a 500-ml flask, 100 ml of THF was cooled to -78°C, in which 25 g of bis(heptafluoroisopropyl)ketone was dissolved. To the solution, 72 ml of a THF solution of 1.0M methyl lithium was added dropwise, followed by 2 hours of ripening. Methacrylic chloride, 7.9 g, was added dropwise, followed by 2 hours of ripening. The reaction solution was post treated in a conventional manner. The resulting oily substance was distilled in vacuum, collecting 21.5 g of 1,1-bis(heptafluoroisopropyl)ethyl methacrylate. The yield was 70%.

### Synthesis Example 2-1

### Polymerization of 1,1-bis(trifluoromethyl)ethyl methacrylate

In a 500-ml flask, 20 g of 1,1-bis(trifluoromethyl)ethyl methacrylate was dissolved in 100 ml of toluene, oxygen was thoroughly purged from the system, and 0.50 g of an initiator AIBN was admitted. The flask was heated to 60°C, at which polymerization reaction was effected for 24 hours.

To purify the resulting polymer, the reaction mixture was poured into methanol whereupon the polymer precipitated. The procedure of dissolving the collected polymer in acetone and pouring into 5 liters of methanol for precipitation was repeated twice. The polymer was separated and dried. There was obtained 17.2 g of a white polymer, poly(1,1-bis(trifluoromethyl)ethyl methacrylate). This polymer was found to have a Mw of 9,300 g/mol as measured by the light scattering method and a dispersity (Mw/Mn) of 1.85 as determined from the GPC elution curve.

### Synthesis Example 2-2

### Polymerization of 1,1-bis(heptafluoroisopropyl)ethyl methacrylate

In a 500-ml flask, 20 g of 1,1-bis(heptafluoro-isopropyl)ethyl methacrylate was dissolved in 100 ml of toluene, oxygen was thoroughly purged from the system, and 0.31 g of an initiator AIBN was admitted. The flask was heated to 60°C, at which polymerization reaction was effected for 24 hours.

To purify the resulting polymer, the reaction mixture was poured into methanol whereupon the polymer precipitated. The procedure of dissolving the collected polymer in acetone and pouring into 5 liters of methanol for precipitation was repeated twice. The polymer was separated and dried. There was obtained 16.5 g of a white polymer, poly(1,1-bis(heptafluoroisopropyl)ethyl methacrylate). This polymer was found to have a Mw of 8,700 g/mol as measured by the light scattering method and a dispersity (Mw/Mn) of 1.80 as determined from the GPC elution curve.

### Synthesis Example 2-3

### Copolymerization of 1,1-bis(trifluoromethyl)ethyl methacrylate with Monomer 1 (1:1)

In a 500-ml flask, 10 g of 1,1-bis(trifluoromethyl)ethyl methacrylate and 8.4 g of Monomer 1, shown below, were dissolved in 100 ml of toluene, oxygen was thoroughly purged from the system, and 0.50 g of an initiator AIBN was admitted. The flask was heated to 60°C, at which polymerization reaction was effected for 24 hours.

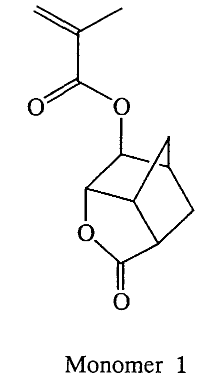

To purify the resulting polymer, the reaction mixture was poured into methanol whereupon the polymer precipitated. The procedure of dissolving the collected polymer in acetone and pouring into 5 liters of methanol for precipitation was repeated twice. The polymer was separated and dried. There was obtained 14.5 g of a white polymer. This polymer was found to have a Mw of 8,500 g/mol as measured by the light scattering method and a dispersity (Mw/Mn) of 1.90 as determined from the GPC elution curve. On ¹H-NMR analysis, the polymer was found to consist of 1,1-bis(trifluoro-methyl)ethyl methacrylate and Monomer 1 in a ratio of 48:52.

### Synthesis Example 2-4

### Copolymerization of 1,1-bis(trifluoromethyl)ethyl methacrylate with Monomer 2 (1:1)

In a 500-ml flask, 10 g of 1,1-bis(trifluoromethyl)ethyl methacrylate and 6.4 g of Monomer 2, shown below, were dissolved in 100 ml of toluene, oxygen was thoroughly purged from the system, and 0.50 g of an initiator AIBN was admitted. The flask was heated to 60°C, at which polymerization reaction was effected for 24 hours.

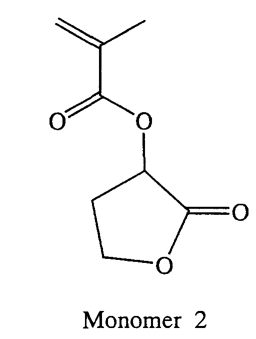

To purify the resulting polymer, the reaction mixture was poured into methanol whereupon the polymer precipitated. The procedure of dissolving the collected polymer in acetone and pouring into 5 liters of methanol for precipitation was repeated twice. The polymer was separated and dried. There was obtained 14.0 g of a white polymer. This polymer was found to have a Mw of 8,200 g/mol as measured by the light scattering method and a dispersity (Mw/Mn) of 1.95 as determined from the GPC elution curve. On ¹H-NMR analysis, the polymer was found to consist of 1,1-bis(trifluoro-methyl)ethyl methacrylate and Monomer 2 in a ratio of 49:51.

### Comparative Polymers

A polymer, designated Comparative Polymer 1, was synthesized from a monodisperse polyhydroxystyrene having a molecular weight of 10,000 and a dispersity (Mw/Mn) of 1.10 by substituting tetrahydropyranyl groups for 30% of the hydroxyl groups. Comparative Polymer 2 was poly(methyl methacrylate) having a molecular weight of 15,000 and a dispersity of 1.7. Comparative Polymer 3 was a novolac polymer having a meta/para ratio of 40/60, a molecular weight of 9,000 and a dispersity of 2.5.

Next, each of the polymers of Synthesis Examples (SE) 2-1 to 2-4 and Comparative Polymers 1 to 3, 1 g, was thoroughly dissolved in 10 g of propylene glycol monomethyl ether acetate (PGMEA), and passed through a 0.2-µm filter, obtaining a polymer solution.

The polymer solution was spin coated onto a MgF₂ substrate and baked on a hot plate at 100°C for 90 seconds, forming a polymer layer of 300 nm thick on the MgF₂ substrate. Using a vacuum ultraviolet spectrometer (VUV200S by Nihon Bunko K.K.), the polymer layer was measured for transmittance at 248 nm, 193 nm and 157 nm. The results are shown in Table 1.

**Table 1**

| Polymer | Transmittance (%) at | | |
|---|---|---|---|
| | 248 nm | 193 nm | 157 nm |
| Polymer of SE2-1 | 93 | 90 | 56 |
| Polymer of SE2-2 | 92 | 90 | 60 |
| Polymer of SE2-3 | 92 | 90 | 40 |
| Polymer of SE2-4 | 93 | 89 | 48 |
| Comparative Polymer 1 | 85 | 1 | 3 |
| Comparative Polymer 2 | 90 | 70 | 1 |
| Comparative Polymer 3 | 70 | 1 | 6 |

### Examples and Comparative Examples

Resist solutions were prepared in a conventional manner by formulating the polymer, photoacid generator, basic compound, dissolution inhibitor and solvent in the amounts shown in Table 2.

On silicon wafers, DUV-30 (Nissan Chemical K.K.) was coated to form films of 55 nm thick so that the reflectance to KrF light (248 nm) was reduced below 1%. On the coated substrates, the resist solutions were spin coated, then baked on a hot plate at 100°C for 90 seconds to give resist films having a thickness of 300 nm.

Using an excimer laser stepper (NSR-2005EX8A, from Nikon Corporation; NA 0.5, σ 0.7, ordinary illumination), the resist films were exposed stepwise while changing the dose every exposure area of 4 mm by 4 mm. Immediately after exposure, the resist films were baked at 110°C for 90 seconds and then developed for 60 seconds with a 2.38% aqueous solution of tetramethylammonium hydroxide. The relationship of resist film retentivity to exposure dose was determined. The dose at which the resist film thickness was zero is designated Eth which is the sensitivity of the resist. The results are also shown in Table 2.

**Table 2**

| Polymer (pbw) | Photoacid generator (pbw) | Basic compound (pbw) | solvent (pbw) | Dissolution inhibitor (pbw) | Eth sensitivity (mJ/cm²) |
|---|---|---|---|---|---|
| SE2-1 (100) | PAG1 (1) | TBA (0.1) | PGMEA (900) | - | 50 |
| SE2-2 (100) | PAG1 (1) | TBA (0.1) | PGMEA (900) | - | 56 |
| SE2-3 (100) | PAG1 (1) | TBA (0.1) | PGMEA (900) | - | 48 |
| SE2-4 (100) | PAG1 (1) | TBA (0.1) | PGMEA (900) | - | 45 |
| SE1 (100) | PAG1 (1) | TBA (0.1) | PGMEA (900) | DRI (10) | 45 |
| SE1 (100) | PAG2 (1) | TBA (0.1) | PGMEA (900) | - | 38 |
| SE1 (100) | PAG1 (1) | TEA (0.1) | PGMEA (900) | - | 53 |
| SE1 (100) | PAG1 (1) | TMMEA (0.2) | PGMEA (900) | - | 55 |

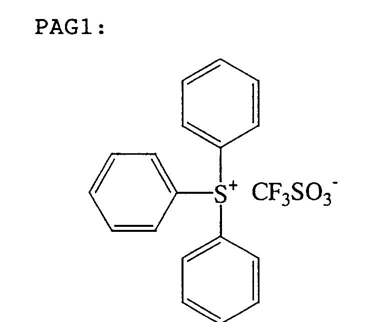

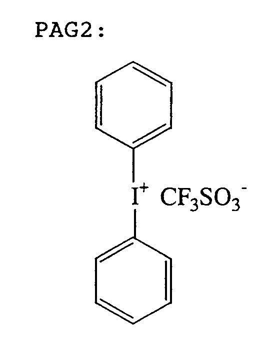

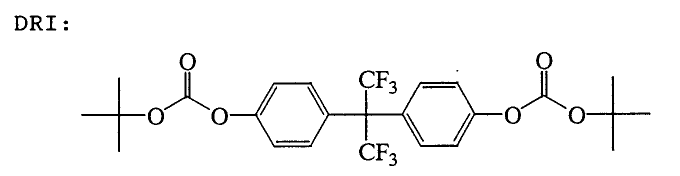

TBA: tributylamine
TEA: triethanolamine 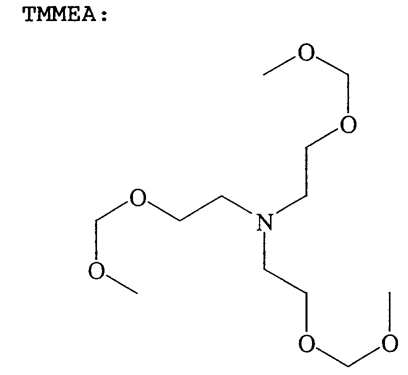
PGMEA: propylene glycol methyl ether acetate

As is evident from Tables 1 and 2, resist materials embodying the invention showed sufficient transparency at the wavelength (157 nm) of F₂ excimer laser. They exhibit positive resist characteristics in that as the dose of KrF exposure increases, the thickness of the resist film left decreases.

Japanese Patent Application No. 2000-038309 is incorporated herein by reference.

Although some preferred embodiments have been described, many modifications and variations may be made thereto in light of the above teachings. It is therefore to be understood that the invention may be practiced otherwise than as specifically described in the examples.

## Claims

1. A polymer having groups of the following general formula (1): 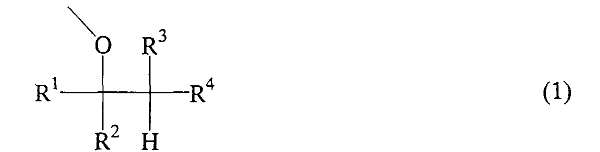 wherein R¹, R², R³ and R⁴ are independently hydrogen, fluorine or unsubstituted or fluorinated, straight, branched or cyclic alkyl groups of 1 to 20 carbon atoms, and at least one of R¹, R², R³ and R⁴ is or contains fluorine.

2. The polymer of claim 1 comprising recurring units represented by any of the following general formulas (2-1), (2-2), (2-3), (2-4) and (2-5): 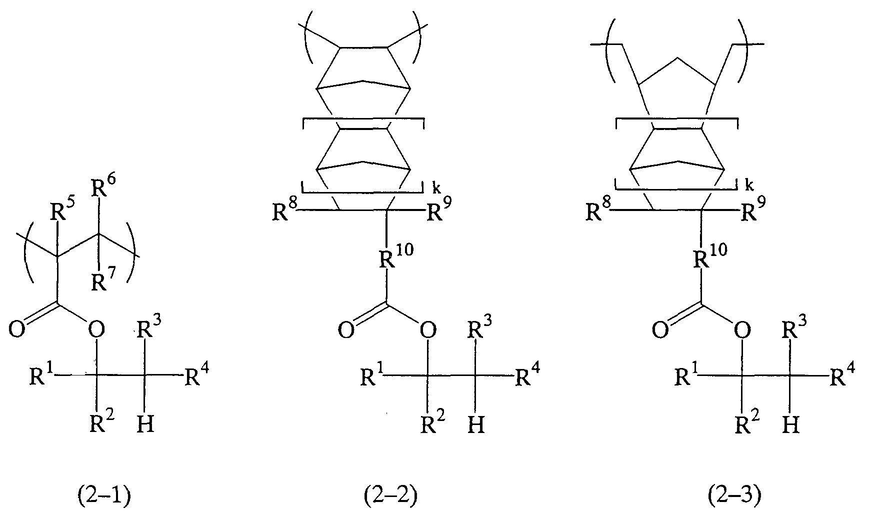 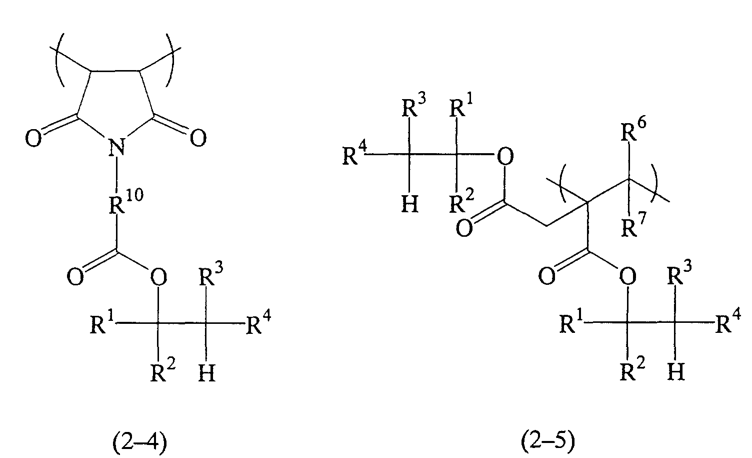 wherein R¹ to R⁴ are as defined above; R⁵, R⁶ and R⁷ are independently hydrogen, fluorine or unsubstituted or fluorinated, straight, branched or cyclic alkyl groups of 1 to 20 carbon atoms; R⁸ and R⁹ are independently hydrogen, methyl or CH₂CO₂R¹¹; R¹⁰ is an unsubstituted or fluorinated, straight, branched or cyclic alkylene group of 1 to 20 carbon atoms; R¹¹ is a substituted or unsubstituted, straight, branched or cyclic alkyl group of 1 to 20 carbon atoms; and k is equal to 0 or 1.

3. A resist composition comprising the polymer of claim 1 or 2.

4. A chemical amplification, positive resist composition comprising
(A) the polymer of claim 1 or 2,
(B) an organic solvent, and
(C) a photoacid generator.

5. The resist composition of claim 4 further comprising a basic compound.

6. The resist composition of claim 4 further comprising a dissolution inhibitor.

7. A process for forming a pattern, comprising the steps of:
applying the resist composition of claim 4 onto a substrate to form a coating,
heat treating the coating and exposing the coating to high energy radiation with a wavelength of up to 300 nm or electron beam through a photo-mask,
optionally heat treating the exposed coating, and developing the coating with a developer.
